# EUROPEAN PATENT APPLICATION

(11) **EP 4 779 874 A1**
(43) Date of publication of application: **22.07.2026**
(21) Application number: 26150231.4
(22) Date of filing: 05.01.2026
(51) Int. Cl.: H03K 17/96

(54) **DEVICE FOR DETECTING USER OPERATION ON ELECTROCAPACITIVE SENSOR**

(30) Priority: 17.01.2025 JP 2025006753
(71) Applicant: Alps Alpine Co., Ltd., Ota-ku, Tokyo 145-8501 (JP)
(72) Inventor: Ichikawa, Teiichi, Iwaki-City, Fukushima (JP)
(74) Representative: Schmitt-Nilson Schraud Waibel Wohlfrom Patentanwälte Partnerschaft mbB

(57) **Abstract**

A device for detecting a user operation on an electrocapacitive sensor is provided, the device including: the electrocapacitive sensor; a lighting device positioned near the electrocapacitive sensor; a RAW detection part configured to detect a value of an electrostatic capacitance of the electrocapacitive sensor as a RAW value; a baseline setting part configured to set a baseline that serves as a reference value for the electrostatic capacitance of the electrocapacitive sensor while user operation detection is at work; a lighting controller configured to turn on the lighting device when, during a period in which the lighting device is turned off, the RAW value becomes less than a difference between the current baseline and a first threshold Th1; and an operation detector configured to detect the user operation on the electrocapacitive sensor when the RAW value is less than the difference between the current baseline and a first threshold Th1.

## Description

This application is based on and claims priority to Japanese Patent Application No. 2025-006753, filed with Japan Patent Office on January 17, 2025.

The present disclosure relates to a technique for detecting user operations on an electrocapacitive sensor.

According to existing techniques for detecting operations on an electrocapacitive sensor: an operation on the electrocapacitive sensor is detected when the value of the electrocapacitive sensor's electrostatic capacitance as detected, or "RAW," is greater than a baseline currently set, by Th1 or more; and no user operation is/will be detected if RAW is not greater than the baseline by Th1 or more. When no user operation is/will be detected, the baseline is controlled towards RAW, whereas, when a user operation is detected, the baseline is retained as is (see, for example, Japanese Patent Application Publication No. 2014-56512). An operation on the electrocapacitive sensor in this case refers to the user's act of touching the electrocapacitive sensor with his/her finger, or the user's act of bringing his/her finger close to the electrocapacitive sensor and touching it.

The present disclosure relates to a device for detecting user operation on electrocapacitive sensor according to the appended claims. Embodiments are disclosed in the dependent claims.
A touch detection system according to an aspect includes a device for detecting a user operation on an electrocapacitive sensor. This device includes:
the electrocapacitive sensor;
a lighting device positioned near the electrocapacitive sensor;
a RAW detection part configured to detect a value of an electrostatic capacitance of the electrocapacitive sensor as a RAW value;
a baseline setting part configured to set a baseline that serves as a reference value for the electrostatic capacitance of the electrocapacitive sensor while user operation detection is at work;
a lighting controller configured to turn on the lighting device when, during a period in which the lighting device is turned off, a difference between the RAW value and the baseline currently set in the baseline setting part exceeds a first predetermined level; and
an operation detector configured to detect the user operation on the electrocapacitive sensor based on the difference between the RAW value and the current baseline.

In this device, the baseline setting part is further configured to:
when the difference between the RAW value and the current baseline is less than a second predetermined level, the second predetermined level being less than or equal to the first predetermined level, adjust the current baseline towards the RAW value;
when the difference between the RAW value and the baseline is not less than the second predetermined level, retain the current baseline as is; and
when turn-on of the lighting device causes an increase of temperature, followed by a change in the electrostatic capacitance of the electrocapacitive sensor in a first predetermined direction, adjust the current baseline by a predetermined amount, in the first predetermined direction.

FIG. 1 is a diagram showing an example structure of a data processing system according to an embodiment of the present disclosure;
FIG. 2 is a diagram showing how an electrocapacitive sensor and an LED are positioned according to an embodiment of the present disclosure;
FIG. 3 is a flowchart showing an example of a baseline tracing process according to an embodiment of the present disclosure;
FIG. 4 is a flowchart showing an example of a baseline temperature correction process according to an embodiment of the present disclosure;
FIG. 5A and FIG. 5B are diagrams showing examples of detecting a user operation in relation to an electrocapacitive sensor according to an embodiment of the present disclosure;
FIG. 6 is a flowchart showing an additional example of a baseline temperature correction process according to an embodiment of the present disclosure;
FIG. 7A and FIG. 7B are diagrams showing additional examples of detecting a user operation in relation to an electrocapacitive sensor according to an embodiment of the present disclosure; and
FIG. 8 is a flowchart showing an additional example of a baseline tracing process according to an embodiment of the present disclosure.

According to related techniques such as that disclosed in JP 2014-56512A, a lighting device positioned near an electrocapacitive sensor is turned on when an operation is detected and kept turned on while the operation is being detected. Once the operation has been detected, an increase in temperature, which occurs when the lighting device is detected, results in a change in the electrocapacitive sensor's dielectric constant, which then increases RAW regardless of whether or not the electrocapacitive sensor is operated. In this case, while an operation is detected, the baseline is kept at the value that is set before the lighting device is turned on. Consequently, even after the user finishes operating the electrocapacitive sensor, RAW remains greater than the baseline by Th1 or more, and so user operation detection continues and the lighting device is kept turned on.

In view of the foregoing, the present disclosure aims to accurately detect whether or not a user operation is performed on an electrocapacitive sensor when a lighting device positioned near the electrocapacitive sensor is turned on in response to a user operation on the electrocapacitive sensor being detected.

As described above, the device for detecting a user operation on an electrocapacitive sensor according to the present disclosure is configured such that, when turn-on of the lighting device causes an increase of temperature, followed by a change in the electrostatic capacitance of the electrocapacitive sensor in a certain direction, the baseline, which serves as a reference value when user operation detection is at work, is adjusted by the same amount and in the same direction as the change in the electrostatic capacitance of the electrocapacitive sensor.

This allows the baseline to be maintained at an appropriate value even while the lighting device is turned on, thus preventing or substantially preventing malfunctions from occurring when turn-on of the lighting device causes an increase of temperature, followed by a change in the electrostatic capacitance of the electrocapacitive sensor.

According to the present disclosure, therefore, accurate user operation detection is made possible even when a lighting device positioned near an electrocapacitive sensor is turned on in response to a user operation on the electrocapacitive sensor being detected.

Embodiments of the present disclosure will be described below.

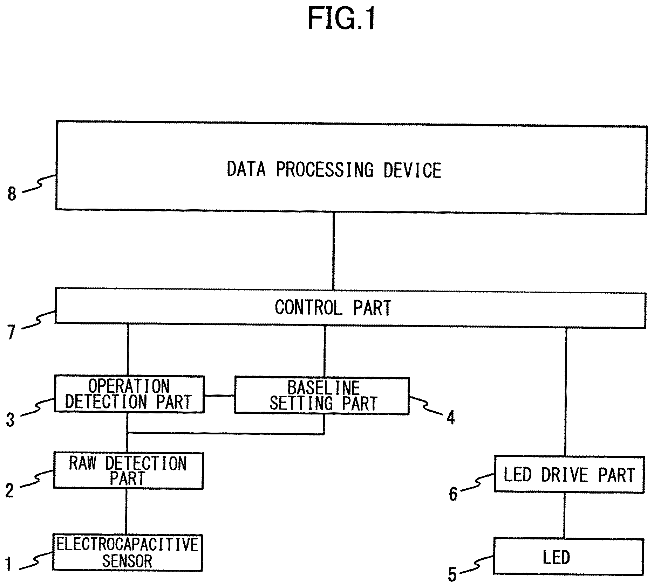

FIG. 1 shows an example structure of a data processing system according to an embodiment. Referring to FIG. 1, the data processing system includes at least an electrocapacitive sensor 1, a RAW detection part 2, an operation detection part 3, a baseline setting part 4, an LED 5, an LED drive part 6, a control part 7, and a data processing device 8.

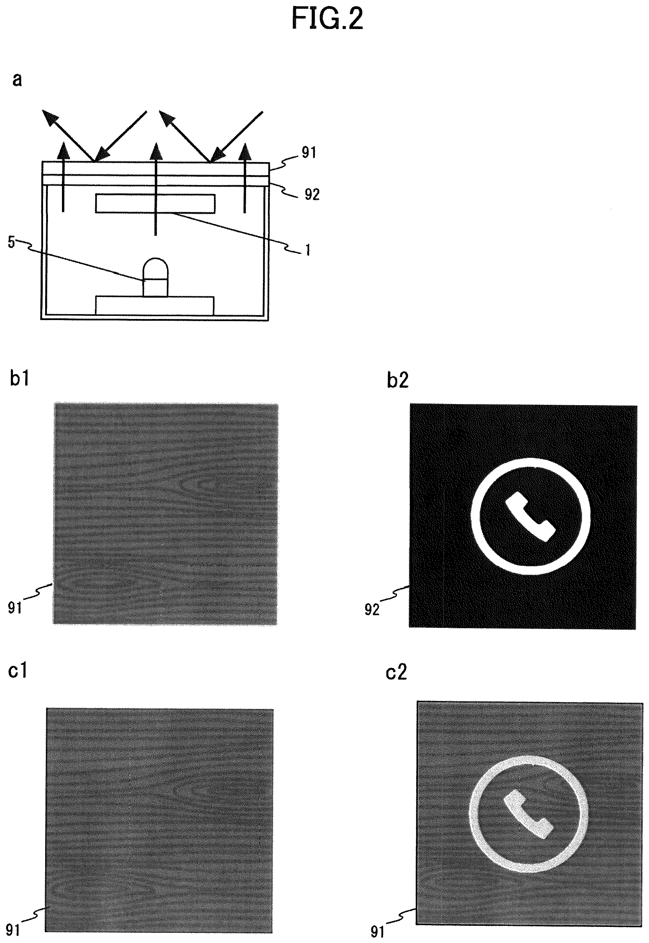

The part (a) in FIG. 2 shows how the electrocapacitive sensor 1 and the LED 5 are positioned relative to each other. The part (a) in FIG. 2 shows that the electrocapacitive sensor 1 and the LED 5 constitute a switch unit together. The switch unit includes at least a decorative plate 91 and a mask plate 92, in addition to the electrocapacitive sensor 1 and the LED 5.

Referring to the part (bl) in FIG. 2, the decorative plate 91 is a plate-shaped member with an outer surface decorated with wood grain or other patterns. The outer surface is exposed to the space where the user is located. Referring to the part (b2) in FIG. 2, the mask plate 92 is a plate-shaped member forming a mask, in which only the part where an icon pattern is displayed allows light to pass through and the rest of the mask blocks light. The mask plate 92 is positioned to face the inner surface of the decorative plate 91. The electrocapacitive sensor 1 is transparent and positioned to face the inner surface of the mask plate 92. The LED 5 is positioned to face the inner surface of the electrocapacitive sensor 1. As shown in the part (a) in FIG. 2, the decorative plate 91 reflects part of the light incident on its outer surface, and allows part of the light incident on its inner surface to pass through. The space on the inner side of the decorative plate 91 is closed and is dark when the LED 5 is not lit.

Therefore, as shown in the part (cl) in FIG. 2, while the LED 5 is not lit, the user's eyes see only the decoration on the outer surface of the decorative plate 91. Also, as shown in the part (c2) in FIG. 2, while the LED 5 is turned on, the user's eyes see an icon overlapping over the decoration on the outer surface of the decorative plate 91.

Referring back to FIG. 1, the electrocapacitive sensor 1 is a self-capacitance sensor, and its electrostatic capacitance value increases when the user's finger is brought closer to (or "approaches") the electrocapacitive sensor 1. The RAW detection part 2 repeats detecting the electrostatic capacitance value of the electrocapacitive sensor 1 as a RAW value (or simply "RAW"). The operation detection part 3 detects whether or not the user is or will be operating the switch unit. To be more specific, a baseline is set in the operation detection part 3, which serves as a reference value in determining whether or not the switch unit has been, is, or will be operated. When RAW detected in the RAW detection part 2 is greater than the baseline set in the operation detection part 3 by an operation detection threshold Th1 or more, the operation detection part 3 yields a positive detection result indicating that a user operation is/will be detected; otherwise, the operation detection part 3 yields a negative detection result indicating that no user operation is/will be detected. Whether or not the user is or will be operating the switch unit is determined based on, for example, whether the user's finger has approached the electrocapacitive sensor 1 or touched the icon display part in the decorative plate 91. An operation in which the user brings his/her finger close to the switch unit (or the electrocapacitive sensor 1, the icon display part in the decorative plate 91, etc.) will also be referred to as a "finger-approaching operation" hereinafter.

The baseline setting part 4 sets the above-described baseline in the operation detection part 3. How this baseline is set will be described later in greater detail.

The control part 7 operates in operation input mode and idle mode. During idle mode, when the operation detection part 3 yields a positive detection result indicating that there is an incoming user operation, the control part 7 instructs the LED drive part 6 to turn on the LED 5, reports the turn-on of the LED 5 to the baseline setting part 4, and transitions to operation input mode. During operation input mode, the control part 7 reports the detection result gained at the operation detection part 3 to the data processing device 8, and the data processing device 8 performs a specific process based on the detection result reported thereto. Furthermore, during operation input mode, when the operation detection part 3 yields a negative detection result indicating that no user operation is/will be detected, and, following this, a predetermined period of time elapses without a positive detection result being yielded, the control part 7 instructs the LED drive part 6 to turn off the LED 5, reports the turn-off of the LED 5 to the baseline setting part 4, and transitions to idle mode.

The LED drive part 6 turns the LED 5 on when instructed by the control part 7 to do so, and turns the LED 5 off when instructed by the control part 7 to do so. Thus, when no overlapping icon is shown in the decorative plate 91 in the part (a) in FIG. 2 and only the decoration on the decorative plate 91 is visible, the LED 5 lights up when the user brings his/her finger close to the switch unit. When an overlapping icon appears on the decorative plate 91 and the user performs an operation on the icon display part, the data processing device 8 performs a process that matches the user operation. When the user finishes the operation and moves his/her finger away from the icon display part and a predetermined period of time elapses, the LED 5 turns off. The icon is no longer displayed on the decorative plate 91, and so the user sees only the decoration on the decorative plate 91.

Next, how the baseline setting part 4 operates when setting the above-described baseline in the operation detection part 3 will be described according to an embodiment. After the data processing system is activated, the baseline setting part 4 performs a baseline tracing process and a baseline temperature correction process in parallel.

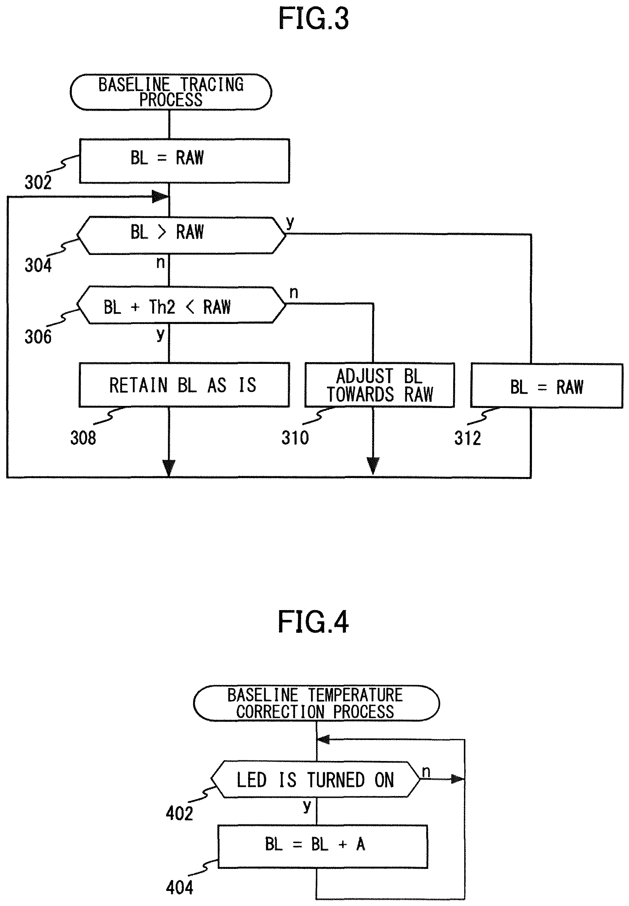

First, a baseline tracing process is shown in FIG. 3. In the accompanying drawings, "BL" stands for the baseline.

As shown in FIG. 4, when the data processing system is activated, the baseline setting part 4 first adjusts the baseline BL to RAW detected in the RAW detection part 2 (step 302). Subsequently, the following process is repeated. That is, the baseline setting part 4 checks whether RAW detected in the RAW detection part 2 is less than the current baseline BL (step 304). If RAW is less than the baseline BL, the baseline setting part 4 replaces the baseline BL with RAW detected in the RAW detection part 2 and sets the new baseline BL in the operation detection part 3 (step 312).

If RAW is not less than the baseline BL (step 304), the baseline setting part 4 checks whether or not the value obtained by adding an incoming operation prediction threshold Th2 to the current baseline BL (hereinafter also referred to as the "sum" of the two values) is less than RAW detected in the RAW detection part 2 (step 306). If the sum of the current baseline BL and the incoming operation prediction threshold Th2 is less than RAW, the baseline setting part 4 predicts an incoming operation and retains the current baseline BL as is (step 308).

Note that the operation detection threshold Th1 for detecting whether or not the operation detection part 3 is operated and the incoming operation prediction threshold Th2 are related by the following: Th1 ≥ Th2. Here, if RAW detected in the RAW detection part 2 is greater than the current baseline BL by more than the incoming operation prediction threshold Th2, the incoming operation prediction threshold Th2 has a value that satisfies "Th1 > Th2," and thereupon the change of RAW detected in the RAW detection part 2 can be seen as one due to a factor that is independent of user operations such as change in environmental temperature, aging/wear, and so forth.

On the other hand, if the sum of the baseline BL and the incoming operation prediction threshold Th2 is not less than RAW, the baseline BL is adjusted towards RAW detected in the RAW detection part 2, and set in the operation detection part 3 (step 310).

In step 310, the baseline BL may be replaced with RAW detected in the RAW detection part 2, or adjusted by adding a predetermined value to the baseline BL, within a range the baseline BL does not exceed RAW (for example, by adding n% of the difference between the baseline BL and RAW to the baseline BL). The baseline tracing process that takes place in the baseline setting part 4 has been described above.

Now, FIG. 4 shows the baseline temperature correction process that takes place in the baseline setting part 4. As shown in FIG. 4, if the status of the LED 5 switches from "OFF" to "ON" during the baseline temperature correction process (step 402), the baseline setting part 4 increases the baseline BL by an amount "A," which corresponds to the amount of change in the electrostatic capacitance of the electrocapacitive sensor 1 upon turn-on of the lighting device (LED 5), and sets the resulting baseline BL in the operation detection part 3 (step 404). Whether the status of the LED 5 switches from "OFF" to "ON" is determined based on a notice of turn-on of the LED 5 from the control part 7.

The amount "A" of change in electrostatic capacitance upon turn-on of the lighting device represents a pre-estimated amount of change in the electrostatic capacitance of the electrocapacitive sensor 1 upon turn-on of the LED 5 and the increase of temperature caused thereby. Here, assume that the electrostatic capacitance of the electrocapacitive sensor 1 increases following an increase in temperature. Furthermore, to provide the amount of change "A" in electrostatic capacitance upon turn-on of the lighting device, an amount of change in the electrostatic capacitance of the electrocapacitive sensor 1, which is caused by an increase in temperature upon turn-on of the LED 5, is determined in advance through experiments or other means, and set in the baseline setting part 4. The amount of change "A" in electrostatic capacitance upon turn-on of the lighting device does not necessarily have to be the same as the amount of change in the electrostatic capacitance of the electrocapacitive sensor 1 occurring as a result of an increase in temperature upon turn-on of the LED 5, and may be a value that is roughly close to the amount of change in the electrostatic capacitance of the electrocapacitive sensor 1 occurring as a result of an increase in temperature upon turn-on of the LED 5.

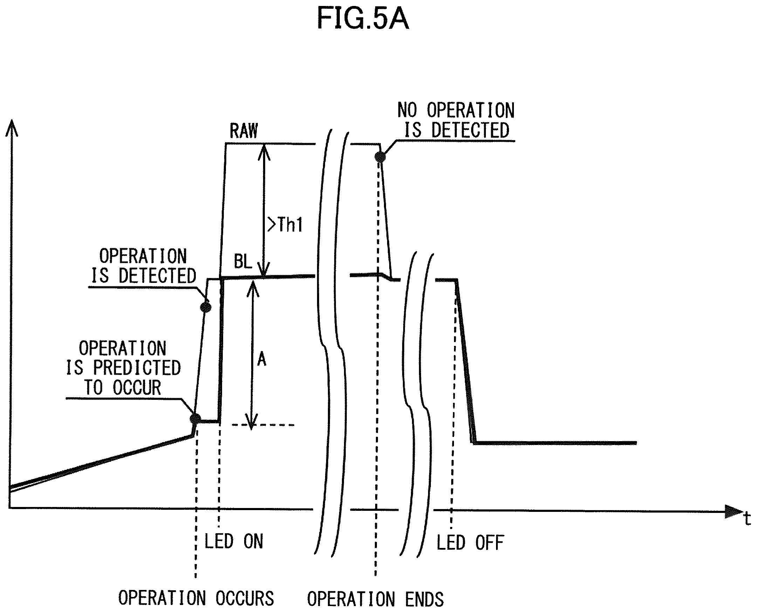

FIG. 5A shows an example of a user operation detection process in this data processing system. To explain this detection operation in terms of time t, when the user's finger is not located near the switch unit, RAW detected in the RAW detection part 2 does not exceed the sum of the current baseline BL and the incoming operation prediction threshold Th2, so that the baseline BL is adjusted towards RAW.

When the user's finger approaches the switch unit and RAW exceeds the sum of the current baseline BL and the incoming operation prediction threshold Th2, a user operation is predicted to occur, and the baseline BL is retained at its current value as is. As the finger approaches further and RAW becomes greater than the fixed baseline BL by more than the operation detection threshold Th1, the operation detection part 3 yields a positive detection result indicating that a user operation is/will be detected. In response to this, the control part 7 turns on the LED 5 and reports this turn-on of the LED 5 to the baseline setting part 4. The turn-on of the LED 5 results in an increase in temperature, followed by an increase in the electrostatic capacitance of the electrocapacitive sensor 1, and thereupon RAW increases by approximately "A." Furthermore, when turn-on of the LED 5 is reported to the baseline setting part 4, the baseline BL increases by "A." As a result of this, while the LED 5 is lit, the baseline BL is substantially equal to RAW when the user's finger is off the switch unit.

From then on, the baseline BL increased by "A" serves as the initial value. During the period in which RAW is greater than the sum of the current baseline BL and the incoming operation prediction threshold Th2, the baseline BL is fixed at the baseline BL value as of when RAW began exceeding the sum. During other periods, the baseline BL is adjusted towards RAW.

When the user brings his/her finger closer to the icon display part and RAW exceeds the sum of the baseline BL and the operation detection threshold Th1, the operation detection part 3 yields a positive detection result indicating that a user operation is/will be detected. When the user finishes the operation and moves his/her finger away from the decorative plate 91 and RAW is no longer greater than the sum of the baseline BL and the operation detection threshold Th1, the operation detection part 3 yields a negative detection result indicating that no user operation is/will be detected.

Then, when the user finishes operating the switch unit and moves his/her finger away from the switch unit, the operation detection part 3 then yields a negative detection result indicating that no user operation is/will be detected. In this state, when a predetermined period of time elapses, the LED 5 is turned off, and RAW decreases by approximately "A." RAW then does not exceed the sum of the current baseline BL and the incoming operation prediction threshold Th2, so that the baseline BL is adjusted towards RAW and continues tracing RAW until RAW exceeds the sum of the current baseline BL and the incoming operation prediction threshold Th2.

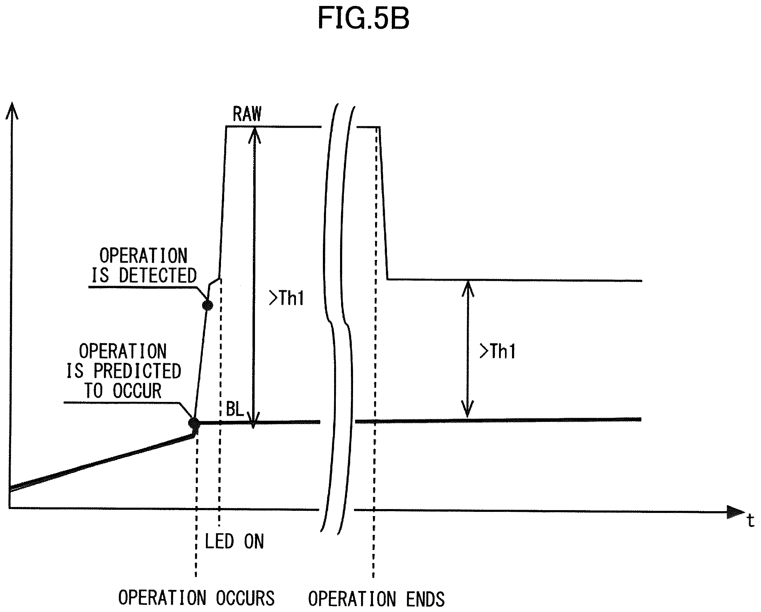

As a comparative example with the present embodiment, FIG. 5B shows the user operation detection that takes place when the baseline temperature correction process is not executed. In FIG. 5B, the operation up until the LED 5 lights up is the same as in FIG. 5A. During the period in which A > Th1 holds and the LED 5 is turned on, RAW remains greater than the sum of the baseline BL and the incoming operation prediction threshold Th2, so that the baseline BL is kept at the value it had earlier when a user operation was predicted, before the LED 5 was turned on. Therefore, when the user moves his/her finger away from the switch unit after the LED 5 lights up, RAW, which is higher by "A" than before the LED 5 was turned on, remains greater than the sum of the baseline BL and the operation detection threshold Th1. Consequently, the operation detection part 3 continues yielding positive detection results indicating that a user operation is/will be detected and does not yield a negative detection result indicating that no user operation is/will be detected. This operation detection is unsound and keeps the LED 5 turned on, potentially resulting in further operational malfunctions.

By contrast with this, according to the present embodiment, the baseline temperature correction process shown in FIG. 4 is performed as shown in FIG. 5A, so that such a problem is prevented or substantially prevented from occurring.

Embodiments of the present disclosure have been described above. Note that, in the baseline temperature correction process shown in FIG. 4, when turn-off of the LED 5 is reported to the baseline setting part 4 from the control part 7, the baseline setting part 4 may lower the baseline BL by the amount "A" of change in electrostatic capacitance upon turn-on of the lighting device, and set the resulting baseline BL in the operation detection part 3.

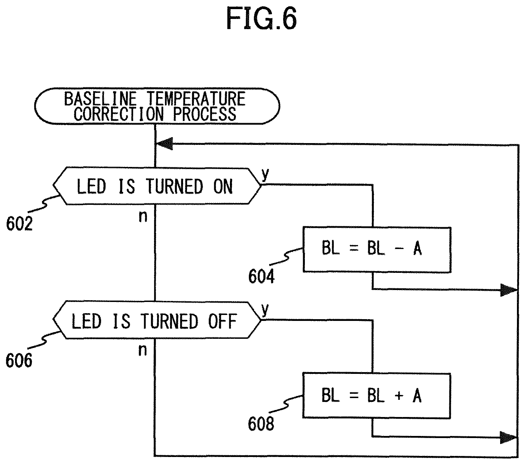

Although a case has been described above in which the electrostatic capacitance of the electrocapacitive sensor 1 increases following a rise in temperature, the present embodiment may replace the baseline temperature correction process with the process shown in FIG. 6 and be applicable to a case where the electrostatic capacitance of the electrocapacitive sensor 1 decreases following a rise in temperature.

In the baseline temperature correction process shown in FIG. 6, the baseline setting part 4 repeats the following process. When the status of the LED 5 switches from "OFF" to "ON" (step 602), the baseline setting part 4 lowers the baseline BL by the amount "A" of change in electrostatic capacitance upon turn-on of the lighting device, and sets the resulting baseline BL in the operation detection part 3 (step 604). When the status of the LED 5 switches from "ON" to "OFF" (step 606), the baseline setting part 4 increases the baseline BL by the amount "A" of change in electrostatic capacitance upon turn-on of the lighting device, and sets the resulting baseline BL in the operation detection part 3 (step 608). Whether the status of the LED 5 changes from "OFF" to "ON" or from "ON" to "OFF" may be determined based on a notice about the ON/OFF status of the LED 5 from the control part 7.

In this process, the amount of change "A" in electrostatic capacitance upon turn-on of the lighting device represents a pre-estimated amount of change in the electrostatic capacitance of the electrocapacitive sensor 1 upon turn-on of the LED 5 and the increase of temperature caused thereby.

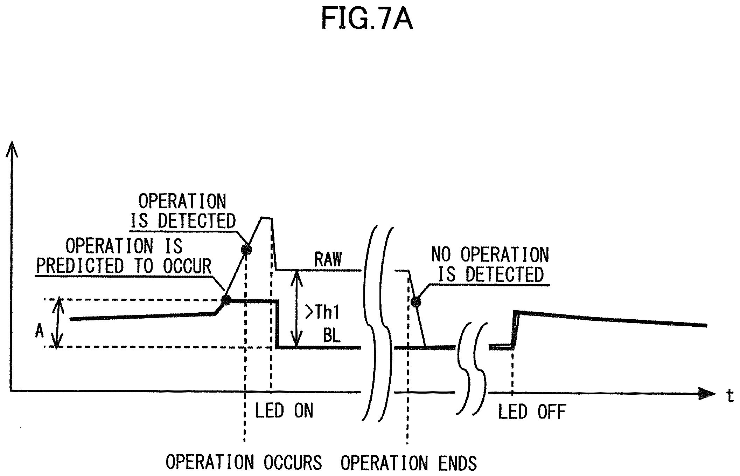

FIG. 7A shows an example of a user operation detection process in which the electrostatic capacitance of the electrocapacitive sensor 1 decreases following an increase in temperature. To explain this detection operation in terms of time t, when the user's finger is not located near the switch unit, RAW detected in the RAW detection part 2 does not exceed the sum of the current baseline BL and the incoming operation prediction threshold Th2, so that the baseline BL is adjusted towards RAW.

When the user's finger approaches the switch unit and RAW exceeds the sum of the current baseline BL and the incoming operation prediction threshold Th2, a user operation is predicted to occur, and the baseline BL is retained at its current value as is. As the finger approaches further and RAW becomes greater than the sum of the fixed baseline BL and the operation detection threshold Th1, the operation detection part 3 yields a positive detection result indicating that a user operation is/will be detected. In response to this, the control part 7 turns on the LED 5 and reports this turn-on of the LED 5 to the baseline setting part 4. The turn-on of the LED 5 results in an increase in temperature, followed by an increase in the electrostatic capacitance of the electrocapacitive sensor 1, and thereupon RAW increases by approximately "A." Furthermore, when turn-on of the LED 5 is reported to the baseline setting part 4, the baseline BL decreases by "A." As a result of this, while the LED 5 is lit, the baseline BL is substantially equal to RAW when the user's finger is off the switch unit.

From then on, the baseline BL increased by "A" serves as the initial value. During the period in which RAW is greater than the sum of the current baseline BL and the incoming operation prediction threshold Th2, the baseline BL is fixed at the baseline BL value as of when RAW began exceeding the sum. During other periods, the baseline BL is adjusted towards RAW.

When the user brings his/her finger closer to the icon display part and RAW exceeds the sum of the baseline BL and the operation detection threshold Th1, the operation detection part 3 yields a positive detection result indicating that a user operation is/will be detected. When the user finishes the operation and moves his/her finger away from the decorative plate 91 and RAW is no longer greater than the sum of the baseline BL and the operation detection threshold Th1, the operation detection part 3 yields a negative detection result indicating that no user operation is/will be detected.

Then, when the user finishes operating the switch unit and moves his/her finger away from the switch unit, the operation detection part 3 then yields a negative detection result indicating that no user operation is/will be detected. In this state, when a predetermined period of time elapses, the LED 5 is turned off, and RAW increases by approximately "A." Also, when turn-off of the LED 5 is reported, the baseline setting part 4 increases the baseline BL by "A," making the baseline BL substantially equal to RAW. Note that the reason the baseline BL is increased by "A" when the LED 5 is turned off is to prevent, or substantially prevent, a situation in which RAW, when increased by "A," becomes greater than the sum of the baseline BL and the incoming operation prediction threshold Th2 and thereby the baseline BL is kept unchanged.

Subsequently, the baseline BL continues tracing RAW until RAW exceeds the sum of the current baseline BL and the incoming operation prediction threshold Th2.

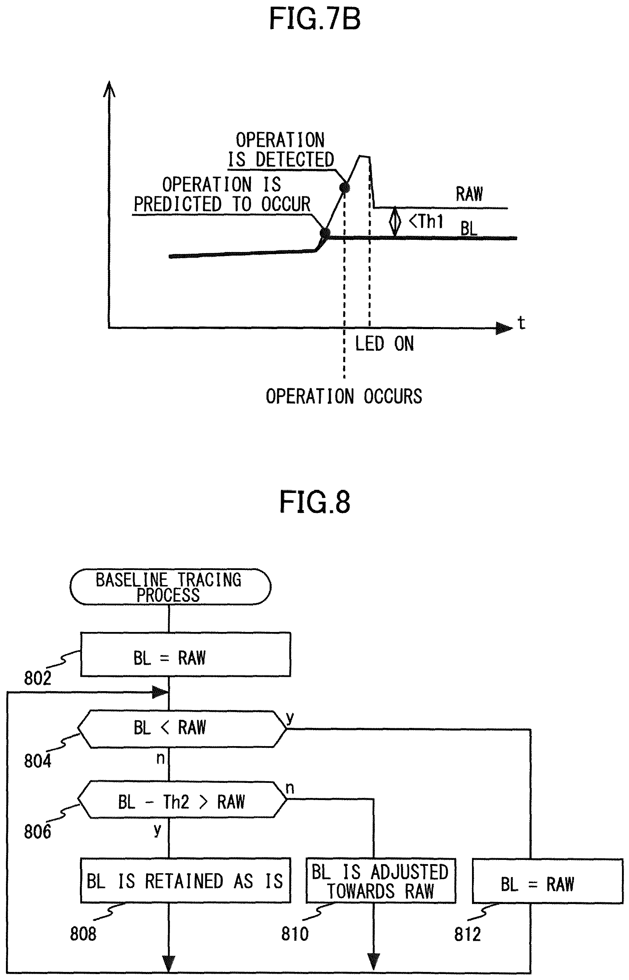

As a comparative example with the present embodiment, FIG. 7B shows the user operation detection that takes place when the baseline temperature correction process is not executed. In FIG. 7B, the operation up until the LED 5 lights up is the same as in FIG. 7A. During the period in which the user performs an operation and RAW-A < Th1 holds, and the LED 5 is turned on, an increase in temperature, caused when the LED is turned on, lowers the electrostatic capacitance of the electrocapacitive sensor 1, leading to RAW < Th1. In this case, a malfunction (detection error) might occur in which, despite the on-going user operation, the operation detection part 3 yields a negative detection result indicating that no user operation is/will be detected.

On the other hand, according to the present embodiment, the baseline temperature correction process shown in FIG. 6 is performed, so that such a detection error is prevented or substantially prevented from occurring, as shown in FIG. 7A.

Although a case has been described above in which the electrocapacitive sensor 1 is a self-capacitance type and its electrostatic capacitance increases when the user's finger approaches, the present embodiment can also be applied to a case in which the electrocapacitive sensor 1 is a mutual capacitance type and its electrostatic capacitance decreases when the user's finger approaches, by making the following changes.

That is, in the event the electrocapacitive sensor 1 is a mutual capacitance type, when RAW detected in the RAW detection part 2 is less than the value obtained by subtracting the operation detection threshold Th1 from the baseline currently set in the baseline setting part baseline setting part 4 (hereinafter also referred to as the "difference" between the two values), the operation detection part 3 yields a positive detection result indicating that a user operation is/will be detected; otherwise, the operation detection part 3 yields a negative detection result indicating that no user operation is/will be detected.

Furthermore, in the event the electrocapacitive sensor 1 is a mutual capacitance type, the baseline setting part 4 performs the baseline tracing process shown in FIG. 8. As shown in FIG. 8, in this baseline tracing process, when the data processing system is activated, the baseline setting part 4 first adjusts the baseline BL to RAW detected in the RAW detection part 2 (step 802).

Subsequently, the following process is repeated. That is, whether or not RAW detected in the RAW detection part 2 is greater than the current baseline BL is determined (step 804), and, if RAW is greater than the baseline BL, the baseline BL is replaced with RAW detected in the RAW detection part 2 and set in the operation detection part 3 (step 812).

If RAW is not greater than the baseline BL (step 804), then, whether or not the difference between the current baseline BL and the incoming operation prediction threshold Th2 is greater than RAW detected in the RAW detection part 2 is determined (step 806). If the difference is not greater than RAW, an incoming operation is predicted, and the current baseline BL is retained as is (step 808).

Here, if RAW detected in the RAW detection part 2 is less than the current baseline BL by more than the incoming operation prediction threshold Th2, the incoming operation prediction threshold Th2 has a value that allows the change of RAW detected in the RAW detection part 2 to be seen as one due to a factor that is independent of user operations such as change in environmental temperature, aging/wear, and so forth.

On the other hand, if the difference between the current baseline BL and the incoming operation prediction threshold Th2 is greater than RAW, the baseline BL is adjusted towards RAW detected in the RAW detection part 2 and set in the operation detection part 3 (step 810).

In step 810, the baseline BL may be replaced with RAW detected in the RAW detection part 2, or adjusted by adding a predetermined value to the baseline BL, within a range the baseline BL does not fall below RAW (for example, by subtracting n% of the difference between the baseline BL and RAW from the baseline BL).

Next, the above embodiment may also be configured such that the brightness level of the LED 5 is adjusted according to the brightness level of ambient light from the surrounding environment, and, furthermore, the amount "A" of change in electrostatic capacitance upon turn-on of the lighting device is adjusted according to the brightness level of the LED 5. In this case, a brightness sensor that detects the brightness level of ambient light may be installed near the switch unit. When turning on the LED 5, the control part 7 may instruct the LED drive part 6 to adjust the brightness level of the LED 5 to a level comparable to the brightness level of ambient light detected by the brightness sensor. When reporting turn-on of the LED 5 to the baseline setting part 4, the control part 7 also reports the brightness level of the LED 5 indicated to the LED drive part 6. Then, the LED drive part 6 drives the LED 5 to have a level of brightness comparable to the brightness level indicated from the control part 7.

For example, the brightness of ambient light may be detected by the brightness sensor in three levels: "bright," "dim," and "dark." Then, the brightness of the LED 5 may be set to a high level when the ambient light is bright, set to a medium level when the ambient light is dim, or set to a low level when the ambient light is dark.

In addition, where the control part 7 controls the brightness level of the LED 5 thus, candidate values Ai may be associated with respective brightness levels of the LED 5 and registered with the baseline setting part 4 in advance. A candidate value "Ai" represents the candidate value associated with the i-th brightness level of the LED 5. In addition, a candidate value "Ai" represents a precalculated amount of change in the electrostatic capacitance of the electrocapacitive sensor 1 caused by an increase of temperature when the LED 5 is turned on at the i-th level of brightness.

Then, in step 402 of the baseline temperature correction process in FIG. 4 and in steps 604 and 606 of the baseline temperature correction process in FIG. 6, the baseline setting part 4 adjusts the baseline by using candidate values Ai, which are associated with respective brightness levels of the LED 5 and which are indicated to the baseline setting part 4 from the control part 7 as the amount of change "A" in electrostatic capacitance upon turn-on of the lighting device.

The above embodiment may furthermore be configured such that the operation detection part 3 detects finger-approaching operations using a threshold Th3 (Th3 < Th1), and the control part 7 switches between operation input mode and idle mode, or turning the LED 5 on and off, in accordance with finger-approaching operations.

In this case, if, during idle mode, the operation detection part 3 yields a positive detection result indicating that a finger-approaching operation is detected, the control part 7 instructs the LED drive part 6 to turn on the LED 5, reports the turn-on of the LED 5 to the baseline setting part 4, and transitions to operation input mode. Once transitioned to operation input mode, the control part 7 reports the subsequent positive and negative detection results in the operation detection part 3 to the data processing device 8.

Also, during operation input mode, if a predetermined period of time elapses after the operation detection part 3 yields a negative detection result indicating that no finger-approaching operation is detected and then a predetermined period of time elapses before the operation detection part 3 yields a positive detection result indicating that a finger-approaching operation or other operations are detected, the control part 7 instructs the LED drive part 6 to turn off the LED 5, reports the turn-off of the LED 5 to the baseline setting part 4, and transitions to idle mode.

In this way, it is possible to turn on the LED 5 and display an icon when the user's finger approaches the switch unit to a certain extent, and, when the user later touches the icon display part of the decorative plate 91 or a finger-approaching operation is detected, the user operation is accepted.

Next, in the event an icon is displayed when a user operation is received as input, the above embodiment may be changed as follows. That is, the control part 7 may normally operate in operation input mode. When the operation detection part 3 yields a positive detection result indicating that a user operation is/will be detected while the LED 5 is turned off, the control part 7 may report this positive detection result to the data processing device 8, instruct the LED drive part 6 to turn on the LED 5, and report the turn-on of the LED 5 to the baseline setting part 4. Conversely, if the operation detection part 3 yields a negative detection result indicating that no user operation is/will be detected while the LED 5 is turned on, the control part 7 may report this negative detection result to the data processing device 8, instruct the LED drive part 6 to turn off the LED 5, and report the turn-off of the LED 5 to the baseline setting part 4.

## Claims

1. A device for detecting a user operation on an electrocapacitive sensor, the device comprising:
the electrocapacitive sensor;
a lighting device positioned near the electrocapacitive sensor;
a RAW detection part configured to detect a value of an electrostatic capacitance of the electrocapacitive sensor as a RAW value;
a baseline setting part configured to set a baseline that serves as a reference value for the electrostatic capacitance of the electrocapacitive sensor while user operation detection is at work;
a lighting controller configured to turn on the lighting device when, during a period in which the lighting device is turned off, a difference between the RAW value and the baseline currently set in the baseline setting part exceeds a first predetermined level; and
an operation detector configured to detect the user operation on the electrocapacitive sensor based on the difference between the RAW value and the current baseline,
wherein the baseline setting part is further configured to:
when the difference between the RAW value and the current baseline is less than a second predetermined level, the second predetermined level being less than or equal to the first predetermined level, adjust the current baseline towards the RAW value;
when the difference between the RAW value and the baseline is not less than the second predetermined level, retain the current baseline as is; and
when turn-on of the lighting device causes an increase of temperature, followed by a change in the electrostatic capacitance of the electrocapacitive sensor in a first predetermined direction, adjust the current baseline by a predetermined amount, in the first predetermined direction.

2. A device for detecting a user operation on an electrocapacitive sensor, the device comprising:
the electrocapacitive sensor;
a lighting device positioned near the electrocapacitive sensor;
a RAW detection part configured to detect a value of an electrostatic capacitance of the electrocapacitive sensor as a RAW value;
a baseline setting part configured to set a baseline that serves as a reference value for the electrostatic capacitance of the electrocapacitive sensor while user operation detection is at work;
a lighting controller configured to turn on the lighting device when, during a period in which the lighting device is turned off, the RAW value exceeds a sum of the current baseline and a first threshold Th1; and
an operation detector configured to detect the user operation on the electrocapacitive sensor when the RAW value is greater than the sum of the current baseline and the first threshold Th1,
wherein the baseline setting part is further configured to:
when the RAW value is not greater than a sum of the current baseline and a second threshold Th2, the second threshold Th2 being less than or equal to the first threshold Th1 so that |Th2| ≦ |Th1| holds, adjust the current baseline towards the RAW value;
when the RAW value is greater than the sum of the baseline and the second threshold Th2, retain the current baseline as is; and
when turn-on of the lighting device causes an increase of temperature, followed by a change in the electrostatic capacitance of the electrocapacitive sensor in a first predetermined direction, adjust the current baseline by a predetermined amount, in the first predetermined direction.

3. A device for detecting a user operation on an electrocapacitive sensor, the device comprising:
the electrocapacitive sensor;
a lighting device positioned near the electrocapacitive sensor;
a RAW detection part configured to detect a value of an electrostatic capacitance of the electrocapacitive sensor as a RAW value;
a baseline setting part configured to set a baseline that serves as a reference value for the electrostatic capacitance of the electrocapacitive sensor while user operation detection is at work;
a lighting controller configured to turn on the lighting device when, during a period in which the lighting device is turned off, the RAW value becomes less than a difference between the current baseline and a first threshold Th1; and
an operation detector configured to detect the user operation on the electrocapacitive sensor when the RAW value is less than the difference between the current baseline and a first threshold Th1,
wherein the baseline setting part is further configured to:
when the RAW value is not less than the difference between the current baseline and a second threshold Th2, the second threshold Th2 being less than or equal to the first threshold Th1 so that |Th2| ≦ |Th1| holds, adjust the current baseline towards the RAW value;
when the RAW value is less than the difference between the current baseline and the second threshold Th2, retain the current baseline as is; and
when turn-on of the lighting device causes an increase of temperature, followed by a change in the electrostatic capacitance of the electrocapacitive sensor in a first predetermined direction, adjust the current baseline by a predetermined amount, in the first predetermined direction.

4. The device according to claim 2 or 3, wherein an absolute value of the first threshold Th1 is greater than an absolute value of the second threshold Th2 so that |Th2| < |Th1| holds.

5. The device according to one of claims 1 to 4, wherein the predetermined amount is set in advance as an amount by which the electrostatic capacitance of the electrocapacitive sensor changes following the increase of temperature occurring when the lighting device is turned on.

6. The device according to one of claims 1 to 5,
wherein, during a period in which the lighting device is turned on, a brightness level of the lighting device is adjustable,
wherein the lighting controller is further configured to adjust the brightness level of the lighting device in accordance with a brightness level of ambient light, and
wherein the baseline setting part is further configured to adjust the predetermined amount in accordance with a brightness level of the lighting device that is set in advance for use in the period in which the lighting device is turned on.

7. The device according to one of claims 1 to 6, wherein the baseline setting part is further configured to adjust the current baseline by the predetermined amount, in a second predetermined direction, when the lighting device is turned off, the second predetermined direction being an opposite direction of the first predetermined direction.

8. The device according to one of claims 1 to 7, wherein the lighting controller is further configured to turn off the lighting device when:
the user operation on the electrocapacitive sensor ceases being detected while the lighting device is turned on; or
a predetermined period of time has elapsed since a most recent detection of the user operation of the electrocapacitive sensor.

9. The device according to one of claims 1 to 8, further comprising a switch unit formed with the electrocapacitive sensor, the lighting device, and a plate member having an outer surface on which a predetermined pattern appears only when the lighting device is turned on,
wherein the electrocapacitive sensor is positioned near the plate member, facing an inner surface of the plate member.
